# EUROPEAN PATENT APPLICATION

(11) **EP 1 229 662 A1**
(43) Date of publication of application: **07.08.2002**
(21) Application number: 01500033.4
(22) Date of filing: 06.02.2001
(51) Int. Cl.: H03M 13/29

(54) **Method and device for turbo coding in a satellite data communication**

(71) Applicant: Alcatel Espana, S.A., 28045 Madrid (ES)
(72) Inventor: Prat Aparicio, Josep, 28760 Tres Cantos - Madrid (ES); Rodriguez Martinez, M. Africa, 28005 Madrid (ES)
(74) Representative: Lamoureux, Bernard

(57) **Abstract**

Device for turbo code encoding (13) that applies a turbo code scheme to frames that have a single predetermined length, in such a manner that the frame received whose length is less than the predetermined length is completed with stuffing bits until the predetermined length is reached by a padding device (12).

Thus, a fixed terminal that comprises the turbo code encoder (13) encodes traffic bursts, signalling and control bursts, or similar, which are equal in length, and applies to each data burst received a common puncturing rate as a function of the quality required, and not on the basis of the length of the frame produced by a burst generator.

## Description

### OBJECT OF THE INVENTION

The present invention refers to a method and a device for turbo code encoding of bursts transmitted over an uplink in a satellite communication system in a multimedia broadcasting network, mainly in digital video broadcasting (DVB) applications, which permits the use of standard stations both on the transmitting and on the receiving sides.

The invention proposes the use of a frame structure of predetermined length, with the object of being encoded by means of a single encoding device, turbo code encoder, located in a fixed terminal with return channel from a satellite. In this manner, the decoding tasks are simplified.

### STATE OF THE ART

The EN 301 790 V1.2.2 (2000-12) standard of the ETSI (European Telecommunications Standards Institute) entitled: "Digital Video Broadcasting (DVB); Interaction channel for satellite distribution systems", the content of which is included in this description by reference, refers to a simplified communication model, based on the OSI communication model, for interactive satellite networks that provide DVB services.

The standard mentioned has, among other objectives, that of defining a basic structure for the frame of data bursts that are transmitted over an uplink or return channel, from an end user to a services provider via a fixed terminal, a satellite, or similar.

For example, it defines two different basic types of frame for transporting useful data in traffic bursts. The two basic types of frame are ATM (asynchronous transfer mode) cell and MPEG2-TS packet.

The useful load length in an ATM frame is 53 bytes, and the useful load length in an MPEG2-TS frame is 188 bytes. A traffic burst carries, therefore, one or various frames of the ATM type or of the MPEG2-TS type.

Likewise, the standard mentioned defines other basic types of frame for transporting other types of data in traffic bursts for other purposes, for example a synchronisation burst SYNC and a common signalling channel CSC burst. The first of these is intended to maintain the synchronisation and to transmit control information to the system, and its length depends on the use made of it by a network control centre (NCC) and said length is based neither on ATM frames, nor on MPEG2-TS frames.

A fixed terminal with return channel from a satellite RCST employs the latter type of frame, namely that of common signalling channel CSC, with the purpose of being identified during the setting up of a return channel, and has a frame length of 16 bytes.

In a system in which a transparent satellite is used, said bursts are received directly by the network control centre. In the case of a system in which a regenerative satellite is employed, all the information transmitted by an end user is decoded on board the satellite, including said synchronisation SYNC and common signalling channel CSC bursts.

The EN 301 790 V1.2.2 standard defines various encoding schemes (see section 6.4 of said standard). One of the encoding schemes defined is that known as turbo code, which is not described as it is known in the state of the art, for example in section 6.4.4 of the EN 301 790 V1.2.2 standard. A block diagram of a turbo code encoder can be seen in figure 12 of said standard.

As a result of handling frames of different lengths, the turbo code encoder is adapted for handling these. Thus, the turbo code encoder encodes the frames received and applies to each one of them a puncturing rate, for the purpose of suitably protecting them against errors during transmission.

The puncturing rate is selected as a function of the length of the frame received. For example, the frames of less length are more sensitive to errors during transmission. In consequence, the turbo code encoder applies the most suitable puncturing rate for protecting each type of frame against errors in transmission.

The fact that the bursts are of different length and different puncturing rate implies a more complex turbo code decoder, given that it has to work with different lengths and different puncturing rates.

When referring to greater complexity, this signifies that the tasks to be performed occupy more logic gates in a design of an integrated circuit, which means greater power consumption and a greater number of devices, which signifies an increase in weight. The weight and the consumption are two very critical parameters in a satellite, since they have a very direct impact on its price.

Thus, it is necessary to define a method and a device of turbo code encoding that complies with the EN 301 790 V1.2.2 standard and permits the development of a turbo code decoder of straightforward circuitry of reduced power consumption and weight, in order that in the event of locating the mentioned turbo code decoder on board a satellite, the latter is not increased in weight and in power consumption, which would penalise the satellite heavily.

### CHARACTERISATION OF THE INVENTION

To overcome the drawbacks mentioned above, the present invention provides a turbo code encoder that applies a turbo code encoding scheme to frames received and which have a single predetermined length.

Consequently, the frames received that have a length less than the predetermined length have to be completed with stuffing bits until the predetermined length with which the turbo code encoder encodes them is reached.

Thus, a fixed terminal which has a turbo code encoder encodes traffic bursts, signalling and control bursts, or similar, which are equal in length, and applies to each data burst received a common puncturing rate as a function of the quality required, and not on the basis of frame length produced by a burst generator.

An advantage obtained with the invention is that the turbo code decoder has a more straightforward circuitry, handles frames of equal length and selects the puncturing rate from a more reduced set of puncturing rates.

Another advantage is that the functions performed by a turbo code decoder are more straightforward as a consequence of its working with frames of a single length and with a reduced set of puncturing rates: Therefore, the circuitry of the turbo code decoder is simple, since the tasks to be carried out occupy fewer logic gates and, in consequence, its power consumption is lower.

In the case in which the turbo code decoder is located on board a satellite, all the aforementioned is beneficial to the satellite since the overall cost thereof is less, because its weight is less and the power consumption lower.

### BRIEF DESCRIPTION OF THE FIGURES

A more detailed explanation of the invention is given in the following description, based on the attached figures, in which:
- figure 1 shows, in a schematic form, a fixed terminal that includes a turbo code encoder according to the invention, and
- figure 2 shows, in a schematic form, a fixed terminal selector module according to the invention.

### DESCRIPTION OF THE INVENTION

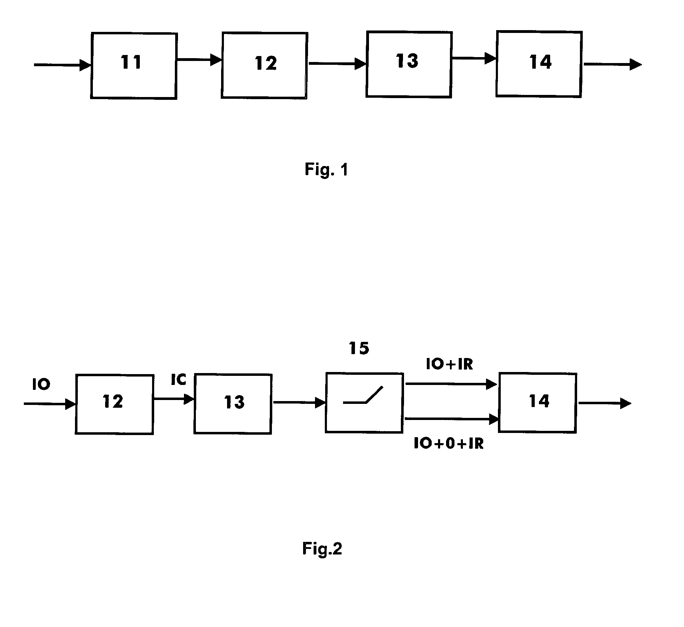

In figure 1 are shown some of the processes that have to be performed by a fixed RCST terminal prior to transmitting a modulated signal over a return channel to a service provider.

Thus, a source of information (not shown) sends a data stream to an input of a burst module 11, which produces at one output traffic bursts IO, shown in figure 2, which transport frames of different lengths, for example an ATM frame that has a length of 53 bytes, an MPEG2-TS frame the length of which is 188 bytes, a common signalling channel CSC frame that has a length of 16 bytes, etc.

The bursts produced are sent to an input of a padding device 12, with the objective of obtaining equal length frames at an output, said frames being applied to an input of a turbo code encoder 13.

The padding device 12 determines the length of each frame received by means of analysis, and adds stuffing bits to that frame received whose length proves to be less than a predetermined length, for example 188 bytes.

For example, a CSC burst of 16 bytes is completed with stuffing bits, for example logical zeros, up to a length of 188 bytes, within the padding device 12.

Next, the turbo code encoder 13 carries out the encoding of the frames of equal length according to a turbo code encoding scheme, known in the state of the art, and generates additional redundancy information IR, according to the puncturing rate set and the frame size, for example for a frame size of 188 bytes and a puncturing rate of 4/5, the redundancy information IR is 47 bytes.

This redundancy information IR, constant for a given puncturing rate since the frames are uniform in size, is added to the information prior to the IC encoding and sent in a joint manner to a modulator module 14, which produces at an output a modulated signal suitable for being transmitted over a return channel up to a satellite. For example, the modulated signal shall be according to a QPSK modulation, which is not described, as it is well known in the state of the art.

Returning now to figure 2, once the redundancy information IR has been obtained by the turbo code encoder 13, this redundancy information IR can be added directly to the information IC provided by the padding device 12, for example, in the previous example, the CSC burst of 16 bytes is completed up to 188 bytes and encoded with a puncturing rate of 4/5. In consequence, the turbo code encoder 13 applies to the modulator module 14 a total of 235 bytes, namely, 188 + 47 = 235 bytes.

A further option is to add to the information IO prior to the padding device 12 the redundancy information IR, for the same example, the turbo code encoder 13 applies to the modulator module 14 a total of 63 bytes, namely the 16 information bytes of the CSC burst plus the 47 bytes of the redundancy information IR. This last option proves more efficient from the transmission point of view.

A selector module 15 is connected between the turbo code encoder 13 and the modulator module 14, for the purpose of deciding which of the two previously outlined options is to be applied to the modulator module 14.

For example, a CSC burst with a length of 16 bytes is completed with stuffing bits, for example logical zeros, up to a length of 188 bytes, within the padding device 12. This completed burst is applied to the turbo code encoder 13 in order to proceed to its encoding.

The turbo code encoder 13 obtains information on redundancy according to the size of the padded information, which it adds to said padded information. The selector device 15 has means for suppressing or not the stuffing information introduced by the padding device 12, for the purpose of boosting the amount of useful information transmitted by the modulator module 14. Thus, the modulator module14 can apply the modulation process to the information IO, before the padding device 12, plus the redundancy information IR; or to the padded information IC, after the padding device 12, plus the redundancy information IR.

## Claims

1. **Device for turbo code encoding** that uses a turbo code encoding scheme for encoding frames that transport data in traffic bursts, **characterised in that** the turbo code encoder (13) is adapted for applying the turbo code encoding scheme to frames of a predetermined length.

2. **Turbo code encoding device** according to claim 1, **characterised in that** the turbo code encoder (13) receives the frames from a padding device (12).

3. **Turbo code encoding device** according to claim 2, **characterised in that** the padding device (12) is adapted for adding bits to a frame received until its length is equal to the predetermined length.

4. **Turbo code encoding device** according to claim 1, **characterised in that** the turbo code encoder (13) is adapted for using a reduced set of puncturing rates during the encoding of the frame of predetermined length.

5. **Turbo code encoding device** according to claim 1, **characterised in that** a selector module (15) is adapted for suppressing or not the bits added by the padding device (12) of the information produced by the turbo code encoder (13).

6. **Method of turbo code encoding** that uses a turbo code encoding scheme by means of which it encodes frames that transport data in traffic bursts, **characterised in that** the method of turbo code encoding includes the steps of:
- adding bits to a frame received until its length is equal to a predetermined length, and
- applying the turbo code encoding scheme to frames of a single predetermined length.
